# EUROPEAN PATENT APPLICATION

(11) **EP 4 844 420 A1**
(43) Date of publication of application: **25.11.2026**
(21) Application number: 25178290.0
(22) Date of filing: 22.05.2025
(51) Int. Cl.: G01R 31/14, H02H 1/00, G01R 31/12, H02H 3/50

(54) **ARC DISCHARGE EVENT DETECTION**

(71) Applicant: Aptiv Technologies AG, 8200 Schaffhausen (CH)
(72) Inventor: YOUSEF, Sebastian, 44795 Bochum (DE)
(74) Representative: Lewis Silkin LLP

(57) **Abstract**

An apparatus for detecting an electrical arc discharge event in a test circuit. The apparatus operates by introducing an alternating current test signal of a reference frequency onto a power line of a test circuit, and monitoring changes in the frequency of the test signal, relative to the reference frequency that may be caused by an arc discharge event.

## Description

### Field

The present disclosure relates to electrical arc detection and mitigation, and more particularly to an apparatus for detecting and mitigating electrical arc discharge events in high-voltage power distribution networks.

### Background

Electrical systems have evolved significantly over the years to meet increasing power demands. For example, direct current (d.c.) automotive electrical systems have traditionally operated at 12V, but with the growing number of electrical components and the move towards hybrid and fully electric vehicles, higher voltage systems such as 48V have been introduced. These higher voltage systems offer advantages in terms of efficiency of power delivery and reduced wiring weight.

As electrical systems transition to higher voltages, new challenges emerge in ensuring safety and reliability. One such challenge is the increased risk of electrical arcing. Arcing occurs when an electric current flows through a gap between two conductors, creating a visible plasma discharge. In automotive applications, arcing can potentially occur due to damaged wiring insulation, loose connections, or other faults in the electrical system that might be aggravated by mechanical vibrations or vehicle impacts.

The occurrence of electrical arcs in power distribution systems poses several problems. Firstly, arcs generate intense heat that can damage surrounding components and potentially lead to fires. Secondly, arcing events can cause electromagnetic interference, disrupting the operation of sensitive electronic systems. Additionally, sustained arcing can lead to rapid degradation of electrical connections and components, reducing the overall reliability and lifespan of the electrical system.

Conventional protection methods, such as fuses and circuit breakers, may not adequately address the arcing issue in higher voltage systems. Traditional protection devices are primarily designed to respond to overcurrent conditions, but may not react quickly enough to short-duration arcing events or may fail to detect some series arcs that do not draw excessive current.

There is therefore a need to develop an effective means of detecting and mitigating arcing in power supply systems, and embodiments of the present disclosure are developed in this context.

### Summary

According to a first aspect of the present disclosure, there is provided an apparatus for detecting an electrical arc discharge event in a test circuit, comprising a signal generator for generating an alternating current test signal having a reference frequency; a test circuit interface for applying the test signal to a direct current power line of the test circuit; a detector for detecting an alternating current load signal on the power line of the test circuit; a comparator for comparing the frequency of the load signal with the reference frequency, and detecting occurrence of an arc discharge event based on a difference in frequency between the load signal and the reference frequency; and a control output for outputting a control signal to implement a safety function on occurrence of the arc discharge event.

In this way, the apparatus can rapidly detect arc discharge events and implement safety functions to prevent system damage or fires. The apparatus is not reliant on overcurrent detection, and can therefore detect arc discharge events which do not draw large current. The apparatus does not require the computational complexity of a digital signal processor or system-on-a-chip implementation, which ensures wide-ranging compatibility, low cost, and resilience to environmental changes such as those caused by vehicle crashes.

In embodiments, the comparator is arranged to detect occurrence of an arc discharge event if the difference between the frequency of the load signal and the reference frequency exceeds a threshold. In this way false positives can be reduced, while maintaining sensitivity to genuine arc discharge events. This balances the need for reliable detection with avoiding unnecessary system shutdowns.

In embodiments, the comparator is a controller arranged to determine the frequency of the load signal by counting the number of phase cycles of the load signal that are detected within a sampling period. In this way, a computationally leaner frequency determination is made possible than that which requires complex frequency-domain analysis, such as a Fast Fourier Transform.

In embodiments, the controller comprises the signal generator, the apparatus further comprising an amplifier to amplify the test signal output by the signal generator. In this way, integration of the signal generator within the controller reduces the physical size of the apparatus, while the amplifier removes the requirement of the controller to be able to output directly a signal of a particular amplitude.

In embodiments, the controller is further arranged to output a clock signal to the signal generator, the clock signal having the reference frequency such that controller drives the signal generator to generate the test signal at the reference frequency. In this way, a signal generator cam be used which is capable of providing highly stable waveforms.

In embodiments, the controller is further arranged to confirm the detection of an arc discharge event if the magnitude of the current of the load signal meets predetermined conditions. In this way, the apparatus provides a dual-detection approach, supporting the distinction between load variations under normal operating conditions, and arc discharge events.

In embodiments, the test circuit comprises a first shunt resistor arranged in the power line between two inputs of a differential amplifier, the first shunt resistor arranged across two inputs of a first differential amplifier for outputting a first voltage signal, proportional to the current of the load signal, to the controller.

In embodiments, the test circuit interface comprises a decoupling capacitor to decouple the test circuit from the comparator. In this way, the apparatus is not influenced by parasitic effects of the capacitive or inductive load characteristics of the test circuit.

In embodiments, the detector comprises a current sensor decoupled from the power line by the decoupling capacitor, to detect an alternating current component on the power line. In this way, sensitive detection of arc-induced frequency changes is possible without interfering with the normal operation of the test circuit.

In embodiments, the current sensor comprises a second differential amplifier having two inputs connected to a signal detection path between the power line and ground, wherein the signal detection path comprises a second shunt resistor between the first and second inputs, wherein the second differential amplifier outputs a second voltage signal, proportional to the decoupled current of the load signal, to the comparator.

In embodiments, the controller is arranged to store a plurality of time-dependent current profiles of a respective plurality of known arc discharge events, and the controller is arranged to train a neural network, using the time-dependent current profiles, to recognise an arc discharge event from the magnitude of the first voltage signal and the frequency of the second voltage signal. In this way, it is possible to classify characteristic frequency and magnitude variations associated with specific arc discharge event types.

In embodiments, the controller is arranged to access a neural network trained to recognise an arc discharge event from the time-dependent profile of the current of the load signal and to receive an indication from the neural network if an arc discharge event is detected. In this way, arc recognition can be processed by powerful computing models external to the apparatus.

In embodiments, the controller is arranged to select the reference frequency by executing a training process, in which the current sensor detects an alternating current component for a test signal of each of a plurality of test signal frequencies, and a frequency at which the alternating current component comprises the test signal frequency is selected as the reference frequency. In this way, a self-calibration feature is provided, enhancing the versatility and reliability of the arc detection system across various applications and physical configurations, such as wiring lengths and load types.

According to a second aspect of the present disclosure, there is provided a control system comprising the apparatus of the first aspect, a power supply, and a driver circuit for supplying direct current from the power supply to an external load, through the power line of the test circuit, wherein the control output is arranged to cause the driver circuit to be switched off in response to detection of an arc discharge event.

In embodiments, the driver circuit is an electronic fuse coupled to a 48V voltage supply, wherein the control system is an automotive control system.

### Brief Description of Drawings

Illustrative embodiments will now be described with reference to the drawings in which:
Figure 1 is a system diagram of an apparatus for detecting an electrical arc discharge event in a test circuit, according to embodiments of the present disclosure; and
Figure 2 shows the structure of an arc detection apparatus of Figure 1, according to embodiments of the present disclosure.

### Detailed Description

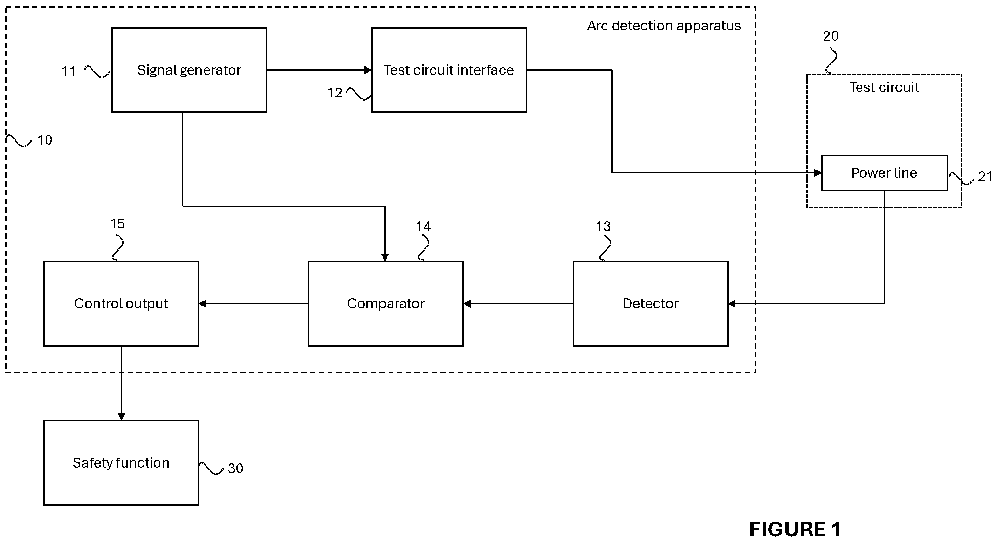

Figure 1 is a system diagram of an arc detection apparatus 10, according to embodiments of the present disclosure, for detecting electrical arc discharge events in a test circuit 20. The apparatus 10 comprises several interconnected components designed to monitor and analyze electrical conditions in the test circuit 20, as described below.

The arc detection apparatus 10 includes a signal generator 11 configured to generate an a.c. test signal having a reference frequency. This signal generator 11 is connected to a test circuit interface 12, which applies the test signal to a power line 21 of the test circuit 20. The test circuit 20 is a high voltage d.c. power line, such as that which exists between a 48V automotive power supply and a load, in which arc discharge events may occur, as described above.

A detector 13 is arranged to detect an a.c. component that is present on the power line 21 of the test circuit 20. The apparatus 10 further includes a comparator 14 that receives input from both the signal generator 11 and the detector 13, to compare the frequency of the detected a.c. component with the reference frequency of the test signal. In embodiments, it is not the signal generated by the signal generator 11 which is provided to the comparator 14, but a value representing the reference frequency of the generated signal. Based on this comparison, the comparator 14 can detect the occurrence of an arc discharge event. Under normal operation, there should be little or no difference between the frequency of the a.c. component and the reference frequency. An arc discharge event, however, may introduce new frequency components, or cause the a.c. component introduced from the test signal to change in frequency, or for the component at the original reference frequency to become undetectable, leading to a clear difference being observed at the comparator 14.

Upon detection of an arc discharge event based on a difference in observed and reference frequencies, a control output 15 of the apparatus 10 is arranged to output a control signal. This control signal is used to implement a safety function 30, outside of the apparatus 10. An example of a safety function 30 is switching off the test circuit 20 to prevent a fire. Another example is the provision of alerts to operators. The simplicity of the arrangement of the apparatus 10 is such that the safety function 30 may be implemented rapidly, preventing damage.

The identification of an arc discharge event based on a frequency discrepancy between a reference signal introduced to the power line 21, and that of an observed a.c. component on the power line 21, addresses a problem seen in conventional systems which operate based on monitoring overcurrent. In series arcing events, associated with a break or gap in a conductor due to, for example, degraded isolation being aggravated by environmental vibrations, a current may flow across the gap but the current is usually of similar magnitude to that carried by the conductor before the arc discharge event, and is therefore not readily detected by current monitors. However, spontaneous creation of arcing current can lead to hotspots or even a fire due to the thermal effects of plasma discharge. It is important to be able to take preventative action quickly, such as a power shutdown, if such a discharge event is observed, to prevent further arcing and potentially serious damage.

The changes to the electrical characteristics of the power line 21 under test, which are caused by a series arc discharge event, can cause the introduction of new a.c. components onto the power line 21. For example, the impedance of the current path changes as a result of the arc that is formed. The resistance of the arc may change rapidly, while thermal effects due to the arcing may induce material changes in the current path. As a consequence, a.c. components at different frequencies may be introduced onto the power line 21, such as harmonic frequencies of resonant frequencies of the conductor. These new frequency components interact with the test signal and may diminish or even eliminate the original reference frequency by causing it to shift. If the reference frequency cannot be identified on the power line 21, the comparator 14 infers that an arc discharge event has occurred, even if the magnitude of the current has not significantly changed.

The principles described above in relation to series arc discharge events also apply to detection of parallel arc discharge events, in which gaps in parallel conductors may cause a connection between different power lines. Such parallel arc discharge events are often associated with significant current increases, due to what is effectively the short-circuiting of different power lines, but it is also the case that changes in a.c. components on the power line 21 will result, which can be identified by the comparator 14.

The comparator 14 is configured in the present embodiments to require low computational complexity, executing relatively simple algorithms with minimal processing in order to provide rapid response times, and to enable continuous monitoring. Avoiding more complex components, such as a digital signal processor (DSP) or a system on a chip (SoC), enables the apparatus 10 to be widely deployed across different types of test circuit 20, while being resilient against degradation effects and environmental changes, in addition to reducing cost. In the case of detection of arc discharge events in automotive test circuits 20, the resilience of the apparatus 10 is advantageous to preserve functionality after a crash or vehicle impact. If the test circuit 20 itself is designed to be resilient to a vehicle impact, and can retain its functionality afterwards, it is possible to supply loads after a crash for emergency cases and preservation of minimum vehicle functions, while protection from arcing events is ensured.

A computationally lean implementation can be achieved in embodiments by using a counter system in the comparator 14 in order to determine the frequency of a test signal which is input. The counter system involves counting the number of complete phase cycles of a signal which occur over a predetermined time period, so that a comparison is performed between two counter values. The phase cycles can be counted in any number of ways, such as by logging peak values or tracking zero-crossings. In contrast to a more computationally complex frequency determination system, such as a Fast Fourier Transform, such a comparator 14 is significantly easier to implement and can be integrated into local control modules associated with the test circuit 20, such as an automotive zonal controller.

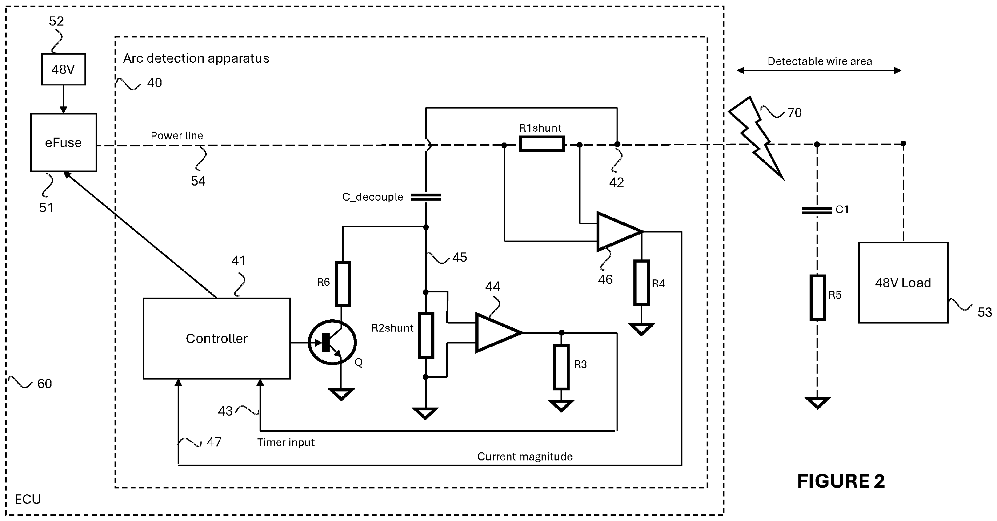

Figure 2 shows details of an implementation of the arc detection apparatus 40 according to embodiments of the present disclosure. Figure 2 is described in connection with detection of an arc discharge event 70 associated with the powering of a 48V test load 53 by an electronic fuse (eFuse) 51 coupled to a 48V d.c. supply 52. The test load 53 is in parallel with a series-linked capacitor C1 and resistor R5 to reduce noise and dissipate the energy of the remaining noise. A high side driver (HSD) may take the place of the eFuse 51. Such a power supply system is increasingly common in automotive systems, in which use of redundant power supply rails is permitted within a vehicle to realise both automated driving functions and safety features, without incurring cost and the space of large printed circuit boards.

The eFuse 51, test load 53 and the power line 54 therebetween are referred to herein as a test circuit. The power line 54 is shown in dashed lines to distinguish it from the circuit connections within the arc detection apparatus 40. The arc detection apparatus 40 comprises passive components, and connects to the power line 54 of the test circuit via shunt resistor R1shunt and a test signal injection point 42. In some embodiments, an electronic control unit 60, ECU, comprises both the arc detection apparatus 40 and the eFuse 51, and either a connection to the power supply 52 or the power supply itself 52, so that the integration of shunt resistor R1shunt occurs within the ECU 60, and the ECU 60 operates to detect an arc discharge event 70 in a portion of the power line 54 which is outside of the ECU 60, namely the detectable wire area.

The arc detection apparatus 40 comprises a controller 41, which performs the function of the comparator 14 of Figure 1. The controller 41 is a microcontroller or processing unit arranged to execute computer-readable instructions. In some embodiments, the controller 41 also performs the safety function 30 and the role of the signal generator 11 of Figure 1.

The controller 41 samples an analogue input signal in order to perform operations to be described below. The sampling is performed using any appropriate technique which can be implemented without the need for complex processing. One example is delta-sigma modulation, which has a high sampling rate, and enables continuous monitoring. Another example is successive approximation analogue to digital conversion (SAR-ADC), with a sampling frequency of the order of 10ms, which is suited to less frequent monitoring of current events.

In the embodiment of Figure 2, the controller 41 samples a timer input signal 43, in order to determine its frequency using a counting method to count the number of phase cycles of the timer input signal 43. The timer input signal 43 is derived from the output of a current sensor 44 which measures the current on a signal detection path 45 between the power line 54 of the test circuit and ground. In the embodiment of Figure 2, the current sensor 44 is a differential amplifier which outputs a signal based on the voltage across a low ohmic shunt resistor, R2shunt, which is proportional to the current through R2shunt. The current through R2shunt is measured on the signal detection path 45. A pull-down resistor R3 at the output of the differential amplifier 44 ensures that floating voltage levels at the output of the differential amplifier 44, that may otherwise occur when there is no current across R2shunt, are eliminated.

The current on the signal detection path 45 is an a.c. component which is present on the power line 54. The d.c. component of the power line 54 is removed from the signal detection path by a decoupling capacitor, C_decouple, which performs the role of the test circuit interface 12 of Figure 1.

In normal operating conditions, the a.c. component sensed by the current sensor 44 corresponds to an a.c. test signal which is introduced to the power line 54 by the signal generator 11. In embodiments, the signal generator 11 is comprised within the controller 41, and the test signal is amplified by a transistor amplifier Q, R6 in order to compensate for the high output impedance of the controller 41. The amplifier Q, R6 may also form part of the test circuit interface 12 of Figure 1. The test signal is at a predetermined reference frequency which is known to the controller 41.

The amplifier Q, R6 provides the test signal to the power line 54 via the decoupling capacitor C_decouple. The decoupling capacitor C_decouple ensures that arc detection apparatus 40 is not influenced by parasitic effects of the capacitive or inductive load characteristics of the test circuit. The test signal is applied to the power line 54 at the test signal injection point 42. In normal operation, the test signal can be observed on the signal detection path 45. The reference frequency is selected in dependence on characteristics of the test circuit, such as the wiring harness and wiring length, load types and degradation effects, such that it can be readily observed is not susceptible to changes in frequency due to fluctuations in the electrical characteristics of the test circuit. In such cases, the controller confirms that the frequency of the timer input signal 43 matches the reference frequency of the test signal, and takes no action in relation to a safety function 30.

In the event of arcing 70, a number of changes may occur in the electrical characteristics of the test circuit, as described above. Such changes may cause a change to both the a.c. and d.c. components of the signal on the power line 54, and the changes to the a.c. component are isolated from the d.c. component via the decoupling capacitor C_decouple on the signal detection path 45. The controller 41 determines that the frequency of the timer input signal 43 does not match the reference frequency, and the controller 41 activates a safety function 30, such as shutdown of the eFuse 51, in order to prevent damage to components of the test circuit and its environment.

The arc detection apparatus 40 comprises a further current sensor 46 which acts to measure current on the power line 54 which is not decoupled by the decoupling capacitor C_decouple. The further current sensor 46 has a structure analogous to the current sensor 44 on the signal detection path 45, and makes use of a differential amplifier taking inputs across the low ohmic shunt resistor R1shunt. R1shunt is positioned upstream, relative to the load 53 of the test circuit, of the test signal injection point 42. The further current sensor 46 provides an output to the controller 41 which is sampled in order to determine the magnitude of the current 47 on the power line 54. The magnitude of the current 47 is used in addition to the frequency of the timer input signal 43, in order to support or confirm the identification of an arc discharge event 70 as a result of a change in frequency of the timer input signal 43 relative to the reference frequency. As such, the arc detection apparatus 40 employs a dual mode detection, based on both the frequency of an a.c. current signal on the power line 54, and the magnitude of the current 47 on the power line 54, which can reduce false positive detection and unintended load disabling.

For example, if a frequency deviation is detected, but the magnitude of the current from the further current sensor 46 is not determined to exhibit a time-varying behaviour which is consistent with a known temporal profile associated with an arc discharge event, it may be inferred that the frequency deviation is a small or temporary drift as a result of a particular change to the behaviour of the test circuit due to, for example, ambient thermal effects, or a change in the behaviour of the load 53, or a vehicle crash. In such cases, it is not necessary for a safety function 30 to be triggered. In contrast, if the frequency deviation is coincident with a change in current magnitude which is significant, or which has a time-varying behaviour associated with a known profile of an arc discharge event, it is determined by the controller 41 that an arc discharge event 70 has occurred. In some embodiments, the controller 41 is configured so that only frequency deviations above a predetermined threshold are permitted indicators of an arc discharge event 70, the threshold representing a sensitivity level of the arc discharge event 70 that may be selected based on the context in which the arc detection apparatus 40 operates, and the structure of the materials used.

The controller 41 stores locally, or accesses an external storage, time-varying current profiles of arc discharge events. In one example of an arc discharge event, a fast initial drop in current is followed by a period of relative stability of the current, with only small fluctuations. In embodiments, a training process is performed in order to train a neural network to detect an arc discharge event 70 based on labelled training data representing current characteristics of known arc discharge events. In embodiments, the training data is obtained from a time-series of current measurements by the controller from the power-line, which are held in a buffer for a predetermined historical window and overwritten in the absence of an arc discharge event 70. If an arc discharge event 70 does occur, the contents of the buffer are labelled and used as training data for the neural network. The neural network may be external to the arc detection apparatus, which enables sophisticated and complex machine-learning techniques to be employed, such as long short-term memory (LTSM) models, with the arc detection apparatus 40 receiving an indication from the neural network of whether or not an arc discharge event 70 has occurred. In other embodiments, a machine-learning algorithm may be executed by the controller 41, or using processing power of the ECU 60.

The dual mode described above also enables training data to be collected for 'false positives', in which a frequency analysis may suggest the presence of an arc discharge event 70, which is not confirmed by the current magnitude measurement. In this way, the number of future false positive determinations, based on frequency measurement alone, can be reduced.

In embodiments, the machine-learning algorithm is able to distinguish a series arcing event from a parallel arcing event, which may affect the nature of the safety function which is executed. For example, a series arcing event may cause only a part of the test circuit to be switched off, whereas a parallel arcing event may cause the entire test circuit to be switched off due to arcing between the power rails.

In some embodiments, it is not necessary to use two current sensors 44, 46, and only one current sensor 44, based on a differential amplifier and R2shunt, is required in order to perform a frequency-dependent identification of an arc discharge event 70. As such, R1shunt, and its associated differential amplifier 46 and pull-down resistor R4, are optional components. In some embodiments, each or either current sensor 44, 46 is implemented using a component such as a Hall sensor instead of a differential amplifier.

The test signal which is generated by the signal generator 11 is of relatively small magnitude, compared to the expected magnitude of the signal on the power line 54, so as not to affect the operation of the test circuit or the load 53. In some embodiments, a standalone signal generator 11, external to the controller 41, is used to generate a signal with a particular reference frequency with high stability and a specific amplitude. As above, in other embodiments, the test signal may be derived from amplification of the clock of the controller 41, converted from the digital to analogue domain, which simplifies the physical layout of the arc detection apparatus 40.

A typical reference frequency is of the order of a few kHz, but this is simply by way of example. The optimum reference frequency is dependent on particular operating environments, and may be determined through a calibration process, in which a series of different test signal frequencies are applied to the power line, and it is observed, using the current sensor 44, whether the a.c. component associated with each of the reference frequencies is present on the power line 54. The physical characteristics of the test circuit may be such that some reference frequencies are more stable on the power line 54 than others, and such reference frequencies can be selected for use in test signals provided by the signal generator 11. The stability should be sufficiently high that it is not necessary to perform intensive training of an arc detection algorithm in order to filter out arcing-associated frequency deviations from deviations due to ambient condition changes. However, the stability should not be so high that an arc discharge event 70 is missed due to no frequency change being introduced. This affects both the reference frequency selected, and the amplitude of the current signal.

Although embodiments are described above in relation to a 48V power supply system, it will be appreciated that the same principles of operation apply to any high voltage system in which an arc discharge event is possible. Typically, such high voltage systems are based on 30V or more. It is also not necessary to restrict the described arc detection apparatus 40 to an automotive context. The nature of the arc detection apparatus 40 is such that its simple components can easily be employed in a variety of contexts. The calibration routine described above may be performed automatically, which further enhances the possibility of using the apparatus in different environments.

It will be appreciated that a variety of modifications to the structure and number of current sensors, the operation of the controller and the decoupling of the test circuit from the arc detection apparatus, without departing from the scope of the claims. In embodiments, the inputs and outputs of the controller, and timer modules used to count phase cycles of signals, can be directly integrated into silicon, reducing costs, and leading to faster reaction times than those possible using discrete components and drivers.

## Claims

1. An apparatus for detecting an electrical arc discharge event in a test circuit, comprising:
a signal generator for generating an alternating current test signal having a reference frequency;
a test circuit interface for applying the test signal to a direct current power line of the test circuit;
a detector for detecting an alternating current load signal on the power line of the test circuit;
a comparator for comparing the frequency of the load signal with the reference frequency, and detecting occurrence of an arc discharge event based on a difference in frequency between the load signal and the reference frequency; and
a control output for outputting a control signal to implement a safety function on occurrence of the arc discharge event.

2. An apparatus according to claim 1, wherein the comparator is arranged to detect occurrence of an arc discharge event if the difference between the frequency of the load signal and the reference frequency exceeds a threshold.

3. An apparatus according to claim 1 or claim 2, wherein the comparator is a controller arranged to determine the frequency of the load signal by counting the number of phase cycles of the load signal that are detected within a sampling period.

4. An apparatus according to claim 3, wherein the controller comprises the signal generator, the apparatus further comprising an amplifier to amplify the test signal output by the signal generator.

5. An apparatus according to claim 3, wherein the controller is further arranged to output a clock signal to the signal generator, the clock signal having the reference frequency such that controller drives the signal generator to generate the test signal at the reference frequency.

6. An apparatus according to any one of claims 3 to 5, wherein the controller is arranged to confirm the detection of an arc discharge event if the magnitude of the current of the load signal meets predetermined conditions.

7. An apparatus according to claim 6, wherein the test circuit comprises a first shunt resistor arranged in the power line between two inputs of a differential amplifier, the first shunt resistor arranged across two inputs of a first differential amplifier for outputting a first voltage signal, proportional to the current of the load signal, to the controller.

8. An apparatus according to any one of the preceding claims, wherein the test circuit interface comprises a decoupling capacitor to decouple the test circuit from the comparator.

9. An apparatus according to claim 8, wherein the detector comprises a current sensor decoupled from the power line by the decoupling capacitor, to detect an alternating current component on the power line.

10. An apparatus according to claim 9, wherein the current sensor comprises a second differential amplifier having two inputs connected to a signal detection path between the power line and ground, wherein the signal detection path comprises a second shunt resistor between the first and second inputs, wherein the second differential amplifier outputs a second voltage signal, proportional to the decoupled current of the load signal, to the comparator.

11. An apparatus according to claim 10, wherein the controller is arranged to store a plurality of time-dependent current profiles of a respective plurality of known arc discharge events, and the controller is arranged to train a neural network, using the time-dependent current profiles, to recognise an arc discharge event from the magnitude of the first voltage signal and the frequency of the second voltage signal.

12. An apparatus according to claim 10, wherein the controller is arranged to access a neural network trained to recognise an arc discharge event from the time-dependent profile of the current of the load signal and to receive an indication from the neural network if an arc discharge event is detected.

13. An apparatus according to any one of claims 9 to 12, wherein the controller is arranged to select the reference frequency by executing a training process, in which the current sensor detects an alternating current component for a test signal of each of a plurality of test signal frequencies, and a frequency at which the alternating current component comprises the test signal frequency is selected as the reference frequency.

14. A control system comprising the apparatus of any one of the preceding claims, a power supply, and a driver circuit for supplying direct current from the power supply to an external load, through the power line of the test circuit, wherein the control output is arranged to cause the driver circuit to be switched off in response to detection of an arc discharge event.

15. A control system according to claim 14, wherein the driver circuit is an electronic fuse coupled to a 48V voltage supply, wherein the control system is an automotive control system.
